# EUROPEAN PATENT SPECIFICATION

(11) **EP 0 638 911 B1**
(45) Date of publication and mention of the grant of the patent: **19.11.1997**
(21) Application number: 94110341.8
(22) Date of filing: 04.07.1994
(51) Int. Cl.: H01F 38/12

(54) **A connection support for ignition coils**
Anschlussträger für Zündspulen
Support de connexion pour bobines d'allumage

(30) Priority: 10.08.1993 IT TO930604
(43) Date of publication of application: 15.02.1995
(73) Proprietor: Cooper Industries, Inc., Houston, Texas 77002 (US)
(72) Inventor: Rossi, Daniele, I-40050 Bologna (IT); Morini, Francesco, I-40141 Bologna (IT)
(74) Representative: Marchitelli, Mauro

(56) References cited:
- EP-A- 0 209 415
- EP-A- 0 387 993
- EP-A- 0 458 755
- FR-A- 2 551 259
- GB-A- 1 583 149
- US-A- 5 225 801

## Description

The present invention relates to a coil ignition unit for an internal combustion engine comprising support means on which ignition transformers are mounted each of which is intended to be connected to at least one associated spark plug, and each comprising a primary winding and a secondary winding disposed about an arm of a respective magnetic core or circuit.

In recent times, the use of ignition systems with static electronic distribution, with ignition coils or transformers mounted directly on the engine, in the vicinity of the associated spark plugs, has become more widespread. For this purpose, solutions have been proposed in which a single ignition coil is coupled to a spark plug or to a pair of spark plugs.

According to another type of solution, the internal combustion engine is associated with an integrated coil ignition unit comprising, in a single support casing, a plurality of ignition coils or transformers. This integrated unit has a plurality of outlets, each of which is coupled to an associated spark plug by a respective interconnection device.

An ignition unit of this kind is disclosed, for instance, in EP-A-0 458 755.

However, this type of integrated ignition unit involves difficulties in the production of the internal connection system both for low and high voltage. In particular, the connection between the outputs of the high voltage, or secondary, windings and the high voltage output paths is critical because of the danger of internal discharge in the high voltage coil.

It is known in the art to produce internal connections by flexible conductors and thus with installations which may be geometrically inaccurate and in any case variable from one component to the other.

In order to overcome this disadvantage, it is proposed that these connections be produced by semirigid conductors. However, this solution has the disadvantage of requiring the conductors to be preformed, which may be a difficult operation.

The object of the present invention is to produce an integral ignition unit which enables all the above disadvantages to be overcome satisfactorily.

According to the present invention, this object is achieved by an ignition unit having the characteristics given in the claims following the present description.

Further advantages and characteristics will become clear from the following detailed description given with reference to the appended drawings, provided by way of non-limiting example, in which:
- Figure 1 shows schematically a component of the ignition unit according to the present invention;
- Figure 2 shows schematically an ignition unit according to the present invention;
- Figure 3 shows the ignition unit of Figure 2 according to a view rotated through 90° and partially in section.

The present invention consists of an integral ignition unit comprising a pre-moulded connection support, complete with high voltage and low voltage conductors. This support enables the windings and high voltage connection paths to be mounted automatically.

The invention will now be described in detail with reference to the drawings relating to a possible embodiment.

The connection system is produced by a frame having a printed circuit and a vetronite support. The specific embodiment relates to a frame for a unit of two coils with a double output (with a lost spark).

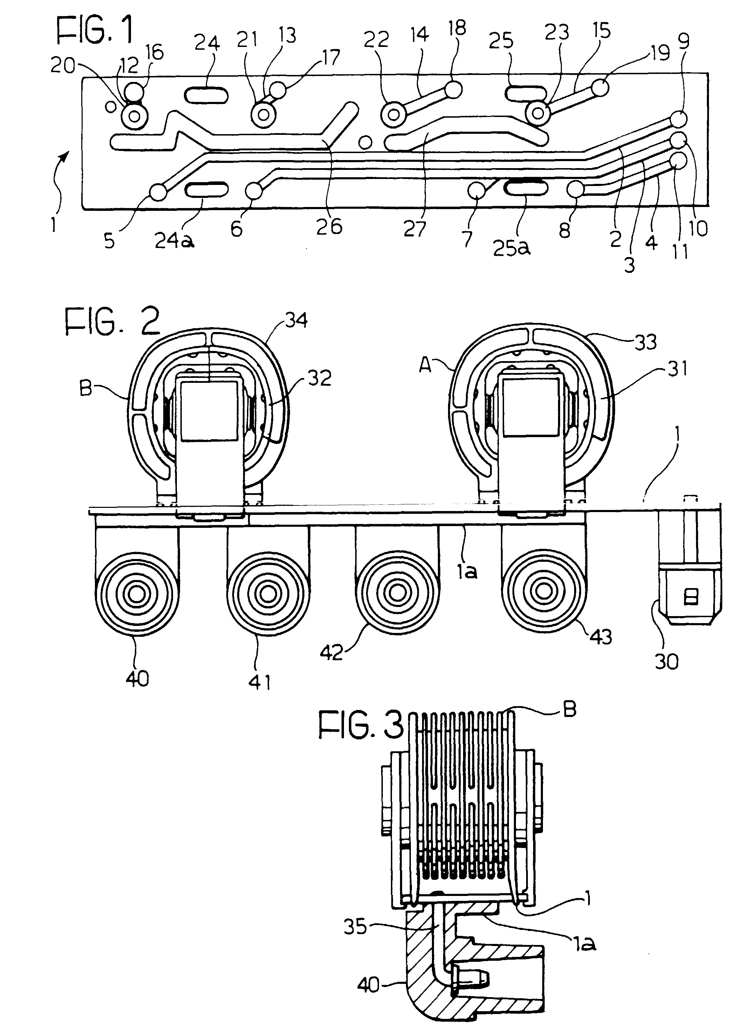

Figure 1 shows at 1 a frame on which low voltage feed conductor tracks 2, 3, 4 are mounted. These tracks are connected to the primary, or low voltage, windings of the coils. The track 3, with positive potential, is connected by welding, on one side, at 10, to a positive terminal of an electrical connector 30 (shown in Figure 2) and, on the other side, at the points 6 and 7, to a positive terminal of primary windings 31, 32 of the coils A, B.

The negative tracks 2 and 4 are connected by welding, on one side, at the points 9 and 11, to negative terminals of the electrical connector 30 (Figure 2) and, on the other side, at the points 5 and 8, to negative terminals of the primary windings 31 and 32 of the ignition coils A, B.

The frame 1 also comprises high voltage tracks 12, 13, 14, 15 connected at the points 16 and 17 to the secondary winding 34 coupled to the primary winding 32. On the other side, at the point 20, the tracks are connected to a conductor 35 of a high voltage path 40. The high voltage path 40 is in turn connected, by a conductor cable, to the respective spark plug (not illustrated). At the point 21 the cable is also connected to the conductor 35 of a high voltage path 41, connected by a conductor cable to the corresponding spark plug. At the points 18 and 19, the cable is further connected to a secondary winding 33 coupled to the primary winding 31 and, on the other side, at the point 22, to the conductor 35 of a high voltage path 42. The high voltage path 42 is in turn connected by a conductor cable to the respective spark plug. At the point 23, the conductor cable is further connected to the conductor 35 of a high voltage path 43. The high voltage path 43 is in turn connected by a conductor cable to the corresponding spark plug.

The frame 1 has slot-shaped holes 24, 24a and 25, 25a used respectively for mechanically connecting the turns of the windings of the ignition coils A, B to the frame 1 itself. The shaped gaps 26 and 27, provided on the frame 1, are used for the passage of impregnating resin and are positioned such that the resin constitutes a layer of insulating material so as to prevent short-circuits between the high voltage tracks and between the high and low voltage tracks.

The high and low voltage tracks may also be arranged on opposite faces of the frame 1.

The high voltage unit further comprises a support 1a carrying the high voltage paths 40, 41, 42, 43.

For better understanding, Figure 3 shows a side view of the unit of Figure 2, showing a high voltage path in section.

One possible manner of assembling the ignition unit according to the embodiment described above will now be described in brief.

The frame 1 is mechanically connected to the support 1a with the paths 40, 41, 42, 43, in such a way that the terminals 35 of the paths 40, 41, 42, 43 affect the holes 20, 21, 22, 23 in the high voltage tracks.

The frame 1 is subsequently mechanically connected to the coils A, B with the primary and secondary windings, in such a way that the terminals of the secondary, high voltage, windings affect the holes 18, 19 and 16, 17 respectively in the high voltage tracks. Further, the terminals of the primary, low voltage, windings, affect the holes 7, 8 and 5, 6 respectively in the low voltage feed tracks 2, 3, 4.

The various connections are welded at this point. The subsequent phase involves the insertion of the electrical connector 30, the conductor bars of which are welded to the terminals 9, 10, 11 of the low voltage tracks 2, 3, 4.

The windings are inserted in a container made of plastics material (not illustrated) and, with the paths turned upwards, the impregnating resin is cast and then polymerised.

At the end, the cores, made of ferromagnetic material, are inserted, and the fastening support (not illustrated) is connected to the internal combustion engine.

Naturally, the principle of the invention remaining the same, the features of embodiment and details of description can be widely varied with respect to what has been described and illustrated without departing from the scope of the present invention.

## Claims

1. A coil ignition unit for a multi-cylinder internal combustion engine, comprising:
- a plurality of ignition coils (A, B) each comprising an ignition transformer;
- first, high voltage electrical connection means (40, 41, 42, 43) each of which can be connected to a respective spark plug;
- second, low voltage electrical connection means (30) which can be connected to a device controlling the spark plugs;
- characterised in that it comprises a frame (1) having a printed circuit and support means (1a) made of insulating material and having a substantially planar shape, the frame carrying, on one surface, tracks made of conductive material forming electrical connections which can connect the ignition transformers to the first electrical connection means (40, 41, 42, 43) and second electrical connection means (30).

2. An ignition unit according to Claim 1, characterized in that the insulating material is vetronite.

3. An ignition unit according to any one of the preceding claims, characterized in that the support means (1a) can be rendered integral with the frame (1) and carries the first electrical connection means (40, 41, 42, 43).

4. An ignition unit according to any one of the preceding claims, characterized in that an insulating material, which electrically insulates the conductor tracks, is cast in a liquid phase and then solidified in a space defined by the frame (1) and by the support means (1a).

5. An ignition unit according to Claim 4, characterized in that the frame (1) has apertures (26, 27) enabling the insulating material to be cast in the liquid phase.

## Patentansprüche

1. Spulenzündeinheit für einen Mehrzylinder-Verbrennungsmotor, die umfaßt:
- eine Vielzahl von Zündspulen (A,B), die jeweils einen Zündtransformator umfassen;
- erste elektrische Hochspannungsverbindungseinrichtungen (40,41,42,43), die jeweils mit einer entsprechenden Zündkerze verbunden werden können;
- eine zweite elektrische Niederspannungsverbindungseinrichtung (30), die mit eine Vorrichtung verbunden werden kann, die die Zündkerzen steuert;
**dadurch gekennzeichnet**, daß sie eine Montageplatte (1) mit einer gedruckten Schaltung und einer Trägereinrichtung (1a) umfaßt, die aus isolierendem Material besteht und eine im wesentlichen plane Form hat, wobei die Montageplatte auf einer Seite Bahnen trägt, die aus leitendem Material bestehen und elektrische Verbindungen bilden, die Verbindung zwischen den Zündtransformatoren der ersten elektrischen Verbindungseinrichtungen (40, 41, 42, 43) und der zweiten elektrischen Verbindungseinrichtung (30) herstellen können.

2. Zündeinheit nach Anspruch 1, **dadurch gekennzeichnet**, daß es sich bei dem isolierendem Material um Vetronit handelt.

3. Zündeinheit nach einem der vorangehenden Ansprüche, **dadurch gekennzeichnet**, daß die Trägereinrichtung (1a) integral mit der Montageplatte (1) ausgeführt werden kann und die ersten elektrischen Verbindungseinrichtungen (40,41,42,43) trägt.

4. Zündeinheit nach einem der vorangehenden Ansprüche, **dadurch gekennzeichnet**, daß ein isolierendes Material, das die Leiterbahnen elektrisch isoliert, in flüssiger Phase vergossen und dann in einem Raum verfestigt wird, der durch die Montageplatte (1) und durch die Trägereinrichtung (1a) gebildet wird.

5. Zündeinheit nach Anspruch 4, **dadurch gekennzeichnet,** daß die Montageplatte (1) Öffnungen (26,27) aufweist, die es ermöglichen, das isolierende Material in der flüssigen Phase zu vergießen.

## Revendications

1. Unité d'allumage à bobine pour moteur à combustion interne à plusieurs cylindres, comprenant :
plusieurs bobines d'allumage (A, B) comprenant chacune un transformateur d'allumage,
des premiers dispositifs de connexion électrique à haute tension (40, 41, 42, 43) pouvant être chacun connecté à une bougie d'allumage respective,
des seconds dispositifs (30) de connexion électrique à basse tension qui peuvent être connectés à un dispositif de commande des bougies d'allumage,
caractérisée en ce qu'elle comporte un châssis (1) ayant un circuit imprimé et un dispositif de support (1a) formé d'un matériau isolant et possédant une configuration pratiquement plane, le châssis portant, sur une surface, des pistes formées d'un matériau conducteur et formant les connexions électriques qui permettent la connexion des transformateurs d'allumage aux premiers dispositifs de connexion électrique (40, 41, 42, 43) et aux seconds dispositifs de connexion électrique (30).

2. Unité d'allumage selon la revendication 1, caractérisée en ce que le matériau isolant est la "Vetronite".

3. Unité d'allumage selon l'une quelconque des revendications précédentes, caractérisée en ce que le dispositif de support (1a) peut être rendu solidaire du châssis (1) et porte les premiers dispositifs de connexion électrique (40, 41, 42, 43).

4. Unité d'allumage selon l'une quelconque des revendications précédentes, caractérisée en ce qu'un matériau isolant, qui peut isoler électriquement les pistes conductrices, est coulé en phase liquide puis solidifié dans un espace délimité par le châssis (1) et par le dispositif de support (1a).

5. Unité d'allumage selon la revendication 4, caractérisée en ce que le châssis (1) a des orifices (26, 27) permettant la coulée du matériau isolant en phase liquide.
